# EUROPEAN PATENT SPECIFICATION

(11) **EP 1 666 969 B1**
(45) Date of publication and mention of the grant of the patent: **10.01.2018**
(21) Application number: 04772518.9
(22) Date of filing: 31.08.2004
(51) Int. Cl.: G03F 7/038, C08G 59/68, H01L 21/027

(54) **PHOTOSENSITIVE INSULATING RESIN COMPOSITION AND CURED PRODUCT THEREOF**
LICHTEMPFINDLICHE ISOLIERENDE HARZZUSAMMENSETZUNG UND AUSGEHÄRTETES PRODUKT DAFÜR
COMPOSITION DE RESINE ISOLANTE PHOTOSENSIBLE ET PRODUIT DURCI ASSOCIE

(30) Priority: 09.09.2003 JP 2003317112
(43) Date of publication of application: 07.06.2006
(73) Proprietor: JSR Corporation, Tokyo 104-0045 (JP)
(72) Inventor: GOTO, Hirohumi, c/o JSR Corporation, Chuo-ku, Tokyo 104-0045 (JP); INOMATA, Katsumi, c/o JSR Corporation, Chuo-ku, Tokyo 104-0045 (JP); IWANAGA, Shin-ichiro, c/o JSR Corporation, Chuo-ku, Tokyo 104-0045 (JP)
(74) Representative: TBK
(86) International application number: PCT/JP2004/012562
(87) International publication number: WO 2005/026841

(56) References cited:
- JP-A- 9 278 866
- JP-A- 10 330 652
- JP-A- 11 148 045
- JP-A- 2000 026 546
- JP-A- 2001 330 953
- JP-A- 2002 040 632
- JP-A- 2003 156 843

## Description

### TECHNICAL FIELD

The present invention relates to a photosensitive insulating resin composition used for forming a surface protective film (overcoat film) or a layer insulating film (passivation film) of an organic semiconductor device or the like and a cured product obtained by curing the composition. More particularly, the present invention relates to a cured product which has excellent resolution as a permanent film resist and is excellent in various properties, such as low-temperature curability, electrical insulation, thermal shock resistance and chemical resistance, and a photosensitive insulating resin composition capable of producing such a cured product.

### BACKGROUND ART

Organic semiconductor materials which are paid attention as third semiconductor materials following Si and GaAs have been recently expected much as electronic device materials of the next generation, and studies and development of them have been made actively.

The organic semiconductor materials can be formed into films at low temperatures of not higher than 150°C, and besides, the degree of freedom in the selection of a substrate used is high, so that there is an advantage that use of the organic semiconductor materials makes it possible to manufacture semiconductor devices easily and simply by a relatively inexpensive manufacturing apparatus. On this account, a great number of organic semiconductor devices, such as organic electroluminescence (EL) display devices having light emission properties, organic memory devices using vinylidene fluoride for ferroelectric layers and organic photoelectric conversion devices for converting light energy into electric energy, have been studied and developed.

For surface protective films and layer insulating films used for semiconductor devices of electronic equipments, photosensitive polyimide resins having excellent heat resistance, mechanical properties and film-forming accuracy (see for example patent document 1) have been heretofore widely employed.

The organic semiconductor materials, however, are inferior to Si, GaAs, etc. in heat resistance, and therefore, there is a problem that conventional materials which need to be cured at a temperature of usually not lower than 300°C, such as photosensitive polyimide resins, and conventional production processes cannot be applied to the formation of surface protective films or layer insulating films.

Patent document 1: Japanese Patent Publication No. 52822/1984

JP 2001 330953 A1 describes radiation sensitive resin composition containing [A] a copolymer of (a1) an unsaturated carboxylic acid and/or its anhydride, (a2) a specified monomer containing an oxetanyl group and (a3) an olefinically unsaturated compound other than the components (a) and (a2) and [B] a 1,2-quinonediazido compound.

### DISCLOSURE OF THE INVENTION

### <PROBLEM TO BE SOLVED BY THE INVENTION>

The present invention is intended to solve such a problem associated with the prior art as described above, and it is an object of the invention to provide a photosensitive insulating resin composition which can be cured at low temperatures without inhibiting functions of an organic semiconductor device or the like, by the use of which a cured product excellent in various properties such as resolution, electrical insulation, thermal shock resistance and chemical resistance can be obtained and which is suitably used for a surface protective film and a layer insulating film of a semiconductor device.

### <MEANS TO SOLVE PROBLEM>

The present inventors have earnestly studied in order to solve the above problem, and as a result, they have found a photosensitive insulating resin composition having excellent properties. Based on the finding, the present invention has been accomplished.

That is to say, the photosensitive insulating resin composition of the present invention comprises a copolymer (A) obtained by copolymerizing monomer components containing a vinyl monomer having an epoxy group and a vinyl monomer having an oxetanyl group and another vinyl monomer, and a photosensitive acid generator (B).

It is preferable that in the photosensitive insulating resin composition of the invention, the photosensitive acid generator (B) is contained in an amount of 0.1 to 20 parts by weight based on 100 parts by weight of the copolymer (A), and that the total amounts of the vinyl monomer having an epoxy group and the vinyl monomer having an oxetanyl group contained in the monomer components are not less than 20 parts by weight based on 100 parts by weight of the monomer components.

### <EFFECT OF THE INVENTION>

The photosensitive insulating resin composition of the invention can be cured at low temperatures and can form a cured product having excellent resolution, electrical insulation, heat resistance, thermal shock resistance and chemical resistance. The photosensitive insulating resin composition of the invention having such properties is suitably used for surface protective films or layer insulating films of electronic parts such as organic semiconductor devices.

### BRIEF DESCRIPTION OF THE DRAWINGS

Fig. 1 is a sectional schematic view of a base material for evaluating thermal shock resistance.
Fig. 2 is a schematic view of a surface of a base material for evaluation.

### <Description of reference numerals>

1: base material for evaluation
2: substrate
3: copper foil

### BEST MODE FOR CARRYING OUT THE INVENTION

The photosensitive insulating resin composition of the invention and a cured product thereof are described in detail hereinafter.

### [Photosensitive insulating resin composition]

The photosensitive insulating resin composition of the invention comprises a copolymer (A) and a photosensitive acid generator (B). In the photosensitive insulating resin composition of the invention, various additives can be further contained when needed.

### (A) Copolymer

The copolymer (A) for use in the invention is obtained by copolymerizing monomer components containing a vinyl monomer having an epoxy group, a vinyl monomer having an oxetanyl group, and another vinyl monomer.

Examples of the vinyl monomers having an epoxy group include glycidyl (meth)acrylate, 3,4-epoxycyclohexylmethyl (meth)acrylate, 2-(3,4-epoxycyclohexyl)ethyl (meth)acrylate and allyl glycidyl ether.

Examples of the vinyl monomers having an oxetanyl group include (3-ethyl-3-oxetanyl)methyl (meth)acrylate.

Examples of other vinyl monomers include:
aromatic vinyl compounds, such as styrene, α-methylstyrene, o-methylstyrene, m-methoxystyrene, p-hydroxystyrene, o-chlorostyrene, m-chlorostyrene, N,N-dimethyl-p-aminostyrene and divinylbenzene;
alkyl (meth)acrylates, such as methyl (meth)acrylate, ethyl (meth)acrylate, n-propyl acrylate, n-butyl acrylate, 2-ethylhexyl (meth)acrylate, stearyl (meth)acrylate, isobornyl acrylate and tricyclo[5.2.1.0^{2,6}]decanyl (meth)acrylate;
unsaturated monocarboxylic acid esters, such as methyl crotonate, ethyl crotonate, methyl cinnamate and ethyl cinnamate;
fluoroalkyl (meth)acrylates, such as trifluoroethyl (meth)acrylate, pentafluoropropyl (meth)acrylate and heptafluorobutyl (meth)acrylate;
siloxanyl compounds, such as trimethylsiloxanyldimethylsilylpropyl (meth)acrylate, tris(trimethylsiloxanyl)silylpropyl (meth)acrylate and di(meth)acryloylpropyldimethylsilyl ether;
mono- or di(meth)acrylates of alkylene glycols such as ethylene glycol, 1,2-propanediol, 1,3-propanediol and 1,6-hexanediol;
alkoxyalkyl (meth)acrylates, such as 2-methoxyethyl (meth)acrylate, 2-ethoxyethyl (meth)acrylate and 3-ethoxypropyl (meth)acrylate;
cyano compounds, such as cyanoalkyl (meth)acrylates, specifically cyanoethyl (meth)acrylate and cyanopropyl (meth)acrylate, acrylonitrile and methacrylonitrile;
oligo(meth)acrylates, such as di(meth)acrylates, tri(meth)acrylates or tetra(meth)acrylates of polyhydric alcohols, specifically glycerol, 1,2,4-butanetriol, pentaerythritol, trimethylolalkane (number of carbon atoms of alkane: e.g., 1 to 3) and tetramethylolalkane (number of carbon atoms of alkane: e.g., 1 to 3);
hydroxyalkyl (meth)acrylates, such as 2-hydroxyethyl (meth)acrylate, 2-hydroxypropyl (meth)acrylate and 3-hydroxypropyl (meth)acrylate;
hydroxyalkyl esters of unsaturated carboxylic acids, such as 2-hydroxyethyl crotonate, 2-hydroxypropyl crotonate and 2-hydroxypropyl cinnamate;
unsaturated alcohols, such as (meth)allyl alcohol;
unsaturated (mono)carboxylic acids, such as (meth)acrylic acid, crotonic acid and cinnamic acid;
unsaturated polycarboxylic acids (anhydrides), such as maleic acid (anhydride), fumaric acid, itaconic acid (anhydride) and citraconic acid, and mono- or diesters thereof;
diene compounds, such as butadiene and isoprene; and
other compounds, such as vinyl chloride, vinyl acetate, cinnamic acid ester, crotonic acid ester, dicyclopentadiene and ethylidenenorbornene.

Of the above compounds, preferable are aromatic vinyl compounds. The above-mentioned other vinyl monomers may be used singly or in combination of two or more kinds.

The copolymer (A) for use in the invention can be prepared by, for example, a known solution polymerization process using a radical polymerization initiator and if necessary in the presence of a chain transfer agent. As a polymerization medium for the solution polymerization, an organic solvent can be preferably employed.

Examples of the organic solvents include:
ethylene glycol monoalkyl ether acetates, such as ethylene glycol monomethyl ether acetate and ethylene glycol monoethyl ether acetate;
propylene glycol monoalkyl ethers, such as propylene glycol monomethyl ether, propylene glycol monoethyl ether, propylene glycol monopropyl ether and propylene glycol monobutyl ether;
propylene glycol dialkyl ethers, such as propylene glycol dimethyl ether, propylene glycol diethyl ether, propylene glycol dipropyl ether and propylene glycol dibutyl ether;
propylene glycol monoalkyl ether acetates, such as propylene glycol monomethyl ether acetate, propylene glycol monoethyl ether acetate, propylene glycol monopropyl ether acetate and propylene glycol monobutyl ether acetate;
cellosolves, such as ethyl cellosolve and butyl cellosolve;
carbitols, such as butyl carbitol;
lactic acid esters, such as methyl lactate, ethyl lactate, n-propyl lactate and isopropyl lactate;
aliphatic carboxylic acid esters, such as ethyl acetate, n-propyl acetate, isopropyl acetate, n-butyl acetate, isobutyl acetate, n-amyl acetate, isoamyl acetate, isopropyl propionate, n-butyl propionate and isobutyl propionate;
other esters, such as methyl 3-methoxypropionate, ethyl 3-methoxypropionate, methyl 3-ethoxypropionate, ethyl 3-ethoxypropionate, methyl pyruvate and ethyl pyruvate;
aromatic hydrocarbons, such as toluene and xylene;
ketones, such as 2-heptanone, 3-heptanone, 4-heptanone and cyclohexanone;
amides, such as N-dimethylformamide, N-methylacetamide, N,N-dimethylacetamide and N-methylpyrrolidone; and
lactones, such as γ-butyrolactone.

The above organic solvents can be used singly or in combination of two or more kinds.

The total amounts of the vinyl monomer having an epoxy group and the vinyl monomer having an oxetanyl group contained in the monomer components are not less than 20 parts by weight, preferably not less than 30 parts by weight, based on 100 parts by weight of the monomer components.

If the total amounts of the monomers are less than 20 parts by weight, satisfactory resolution is not obtained in some cases. Each content of the vinyl monomer having an epoxy group and the vinyl monomer having an oxetanyl group is not less than 1 part by weight, preferably not less than 5 parts by weight, based on 100 parts by weight of the monomer components.

The number-average molecular weight (Mn) of the copolymer (A) for use in the invention, as measured by gel permeation chromatography (GPC), is in the range of usually 1,000 to 100,000, preferably 3,000 to 50,000.

### (B) Photosensitive acid generator

The photosensitive acid generator (B) for use in the invention is a compound which generates an acid upon irradiation with a radiation or the like. By virtue of catalytic action of this acid, the epoxy group and the oxetanyl group in the copolymer (A) undergo ring-opening polymerization reaction and thereby the copolymer (A) is cured. Therefore, by the use of the photosensitive insulating resin composition of the invention, a negative pattern can be formed.

There is no specific limitation on the photosensitive acid generator (B) as long as the generator is a compound which generates an acid upon irradiation with a radiation or the like, and the photosensitive acid generator (B) is, for example, an onium salt compound, a halogen-containing compound, a diazoketone compound, a sulfone compound, a sulfonic acid compound, a sulfonimide compound or a diazomethane compound. Examples of these compounds are given below.

Examples of the onium compounds include iodonium salts, sulfonium salts, phosphonium salts, diazonium salts and pyridinium salts. Preferred examples of the onium salts include
diphenyliodonium trifluoromethanesulfonate, diphenyliodonium p-toluenesulfonate, diphenyliodonium hexafluoroantimonate, diphenyliodonium hexafluorophosphate, diphenyliodonium tetrafluoroborate, triphenylsulfonium trifluoromethanesulfonate, triphenylsulfonium p-toluenesulfonate, triphenylsulfonium hexafluoroantimonate, 4-t-butylphenyl·diphenylsulfonium trifluoromethanesulfonate,
4-t-butylphenyl·diphenylsulfonium p-toluenesulfonate, 4,7-di-n-butoxynaphthyltetrahydrothiophenium trifluoromethanesulfonate,
(4-phenylthio)phenyldiphenylsulfonium hexafluorophosphate and (4-phenylthio)phenyldiphenylsulfonium hexafluoroantimonate.

Examples of the halogen-containing compounds include haloalkyl group-containing hydrocarbon compounds and haloalkyl group-containing heterocyclic compounds. Preferred examples of the halogen-containing compounds include 1,10-dibromo-n-decane, 1,1-bis(4-chlorophenyl)-2,2,2-trichloroethane, and S-triazine derivatives, such as phenyl-bis(trichloromethyl)-S-triazine, 4-methoxyphenyl-bis(trichloromethyl)-S-triazine, styryl-bis(trichloromethyl)-S-triazine and naphthyl-bis(trichloromethyl)-S-triazine.

Examples of the diazoketone compounds include 1,3-diketo-2-diazo compounds, diazobenzoquinone compounds and diazonaphthoquinone compounds. Preferred examples of the diazoketone compounds include 1,2-naphthoquinonediazido-4-sulfonic acid ester compounds of phenols.

Examples of the sulfone compounds include β-ketosulfone compounds, β-sulfonylsulfone compounds and α-diazo compounds of these compounds. Preferred examples of the sulfone compounds include 4-trisphenacylsulfone, mesitylphenacylsulfone and bis(phenacylsulfonyl)methane.

Examples of the sulfonic acid compounds include alkylsufonic acid esters, haloalkylsulfonic acid esters, arylsulfonic acid esters and iminosulfonates. Preferred examples of the sulfonic acid compounds include benzoin tosylate, pyrogallol tristrifluoromethanesulfonate, o-nitrobenzyl trifluoromethanesulfonate and o-nitrobenzyl p-toluenesulfonate.

Examples of the sulfonimide compounds include N-(trifluoromethylsulfonyloxy)succinimide, N-(trifluoromethylsulfonyloxy)phthalimide, N-(trifluoromethylsulfonyloxy)diphenylmaleimide, N-(trifluoromethylsulfonyloxy)bicyclo[2.2.1]hept-5-ene-2,3-dicaboxyimide and
N-(trifluoromethylsulfonyloxy)naphthylimide.

Examples of the diazomethane compounds include bis(trifluoromethylsulfonyl)diazomethane, bis(cyclohexylsulfonyl)diazomethane and bis(phenylsulfonyl)diazomethane.

In the present invention, the above photosensitive acid generators (B) can be used singly or in combination of two or more kinds. From the viewpoint of securing sensitivity, resolution, pattern shape, etc. of the resin composition of the invention, the amount of the photosensitive acid generator (B) used is in the range of 0.1 to 20 parts by weight, preferably 0.5 to 10 parts by weight, based on 100 parts by weight of the copolymer (A). If the amount of the photosensitive acid generator (B) is less than the lower limit of the above range, curing becomes insufficient to sometimes lower heat resistance. If the amount thereof exceeds the upper limit of the above range, transparency to the radiation is lowered to sometimes induce deterioration of the pattern shape.

### Additives

To the photosensitive insulating resin composition of the invention, various additives can be added when needed. Examples of the additives include thermoplastic or thermosetting resins, such as polyimide, acrylic polymer, polyolefin elastomer, styrene/butadiene elastomer, silicone elastomer, diisocyanate compounds (specifically tolylene diisocyanate) or blocked compounds thereof, resins having phenolic hydroxyl group, epoxy resins, resins having oxetanyl group, high-density polyethylene, medium-density polyethylene, polypropylene, polycarbonate, polyarylate, aliphatic polyamide, polyamidoimide, polysulfone, polyether sulfone, polyether ketone, polyphenylene sulfide, (modified) polycarbodiimide, polyether imide, polyester imide and modified polyphenylene oxide. Moreover, adhesion assistant, sensitizing agent, leveling agent, inorganic filler, etc. can be added. Such additives can be used singly or in combination of two or more kinds.

### [Cured product]

The photosensitive insulating resin composition of the invention contains the copolymer (A) obtained by copolymerizing monomer components containing a vinyl monomer having an epoxy group, a vinyl monomer having an oxetanyl group and another vinyl monomer, the photosensitive acid generator (B) and if necessary various additives, and can be cured at relatively low temperatures, and has excellent resolution. A cured product of this composition is excellent in electrical insulation, thermal shock resistance, heat resistance and chemical resistance.

Consequently, the photosensitive insulating resin composition of the invention can be preferably used particularly as a material for surface protective films and/or a material for layer insulating films of electronic parts such as organic semiconductor devices.

The cured product of the invention is obtained by curing the photosensitive insulating resin composition. More specifically, the cured product is prepared in the following manner.

The photosensitive insulating resin composition of the invention is applied to a substrate, for example a silicon wafer, provided with a wiring pattern and then dried to evaporate a solvent and thereby form a coating film. Thereafter, the coating film is exposed to light through a desired mask pattern and subjected to heat treatment (referred to as "PEB" hereinafter) to accelerate curing reaction of the copolymer (A). Then, development is carried out using a developing solution to dissolve and remove an unexposed portion, whereby a coating film of a desired pattern can be obtained. After the development, heat treatment is further carried out to allow the coating film to exhibit insulating film properties, whereby a cured film can be obtained.

Examples of methods to apply the resin composition to the substrate include dipping, spraying, bar coating, roll coating, spin coating and curtain coating. The coating thickness can be properly controlled by selecting coating means or controlling solids concentration or viscosity of the photosensitive insulating resin composition.

Examples of the radiations employable for the exposure include ultraviolet rays from a low-pressure mercury lamp, a high-pressure mercury lamp, a metal halide lamp, a g-line stepper and an i-line stepper, and electron beams and laser beams. The exposure dose is properly selected according to the light source used or the resin film thickness, and in case of irradiation with ultraviolet rays from a high-pressure mercury lamp and a resin film thickness of 5 to 50 µm, the exposure dose is in the range of about 1,000 to 20,000 J/m².

After the exposure, PEB treatment is carried out in order to accelerate curing reaction of the copolymer (A) due to the acid generated. Although the conditions of this treatment vary depending upon the compositional ratio of the resin composition or the film thickness used, the treating temperature is usually not higher than 150°C, preferably 80 to 120°C, and the treating time is in the range of 1 to 60 minutes. When the temperature is in this range, functions of the organic semiconductor device are not inhibited. Thereafter, development is carried out using a developer to dissolve and remove the unexposed potion, whereby a desired pattern is formed. Examples of the developing methods include shower development, spray development, immersion development and paddle development. The development is carried out under the conditions of usually 20 to 40°C and 1 to 10 minutes.

As the developer, an organic solvent can be preferably employed, and specifically, organic solvents previously exemplified as the polymerization media which are employable for preparing the copolymer (A) can be mentioned.

In order to allow the resulting film to sufficiently exhibit insulating film properties, heat treatment is carried out after the development, whereby the resin composition can be sufficiently cured. By carrying out the heat treatment under the curing conditions of a temperature of usually not higher than 150°C, preferably 50 to 120°C, and a period of 30 minutes to 10 hours, the resin composition can be cured without inhibiting functions of the organic semiconductor device. In order to sufficiently promote curing or in order to prevent deformation of the resulting pattern shape, heating may be carried out in two stages. Under such curing conditions as described above, a general oven, an infrared oven or the like can be used as a heating apparatus.

### [EXAMPLES]

The present invention is further described with reference to the following examples, but it should be construed that the invention is in no way limited to those examples. Various properties of a cured product were evaluated in the following manner.

### Resolution

A silicone wafer of 6 inches was spin coated with a photosensitive insulating resin composition and heated on a hot plate at 110°C for 3 minutes to form a uniform coating film having a thickness of 10 µm. Thereafter, the coating film was exposed to ultraviolet rays from a high-pressure mercury lamp through a pattern mask using an aligner (Karl Suss MA-150) in such a condition that the exposure dose at a wavelength of 350 nm became 3,000 to 5,000 J/m². Subsequently, heat treatment (PEB) was carried out at 110°C for 3 minutes by means of a hot plate, and then immersion development was carried out at 23°C for 60 seconds using propylene glycol monomethyl ether acetate. A minimum dimension of the resulting pattern was regarded as a resolution.

### Electrical insulation (volume resistivity)

A SUS substrate was coated with a resin composition and heated on a hot plate at 110°C for 3 minutes to form a uniform resin coating film having a thickness of 10 µm. Thereafter, the resin coating film was exposed to ultraviolet rays from a high-pressure mercury lamp through a pattern mask using an aligner in such a condition that the exposure dose at a wavelength of 350 nm became 3,000 to 5,000 J/m². Subsequently, heat treatment (PEB) was carried out at 110°C for 3 minutes by means of a hot plate, and then the coating film was again exposed to ultraviolet rays from a high-pressure mercury lamp in such a condition that the exposure dose at a wavelength of 350 nm became 3,000 to 5,000 J/m², followed by heating at 120°C for 2 hours by means of a convection type oven, to obtain a cured film. The resulting cured film was treated with pressure cooker test equipment (manufactured by Tabai Espec K.K.) for 168 hours under the conditions of a temperature of 121°C, a humidity of 100% and a pressure of 2.1 atm. Before and after the test, layer volume resistivity was measured to confirm resistance.

### Thermal shock resistance

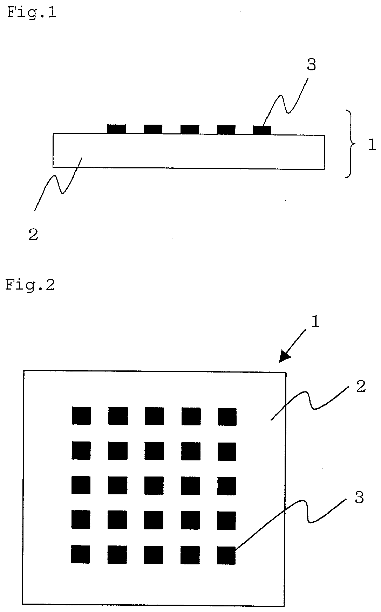

A base material 1 for evaluating thermal shock resistance, said base material having a patterned copper foil 3 on a substrate 2 as shown in Fig. 1 and Fig. 2, was coated with a photosensitive insulating resin composition and heated on a hot plate at 110°C for 3 minutes to form a resin coating film having a thickness of 10 µm on a conductor. Thereafter, the resin coating film was exposed to ultraviolet rays from a high-pressure mercury lamp through a pattern mask using an aligner in such a condition that the exposure dose at a wavelength of 350 nm became 5,000 J/m². Subsequently, heat treatment (PEB) was carried out at 110°C for 3 minutes by means of a hot plate, and then the coating film was again exposed to ultraviolet rays from a high-pressure mercury lamp in such a condition that the exposure dose at a wavelength of 350 nm became 3,000 to 5,000 J/m², followed by heating at 120°C for 2 hours by means of a convection type oven, to obtain a cured film. The resulting base material for evaluation was subjected to a resistance test by means of a thermal shock tester (manufactured by Tabai Espec K.K.) taking "-55°C/30 minutes to 150°C/30 minutes" as one cycle. The number of cycles at the end of which a defect in the cured film such as a crack took place was confirmed.

### Chemical resistance

A silicone wafer of 6 inches was spin coated with a photosensitive insulating resin composition and heated on a hot plate at 110°C for 3 minutes to form a uniform coating film having a thickness of 10 µm. Thereafter, the coating film was exposed to ultraviolet rays from a high-pressure mercury lamp through a pattern mask using an aligner in such a condition that the exposure dose at a wavelength of 350 nm became 5,000 J/m². Subsequently, heat treatment (PEB) was carried out at 110°C for 3 minutes by means of a hot plate, and then the coating film was again exposed to ultraviolet rays from a high-pressure mercury lamp in such a condition that the exposure dose at a wavelength of 350 nm became 3,000 to 5,000 J/m², followed by heating at 120°C for 2 hours by means of a convection type oven, to obtain a cured film. The resulting substrate was immersed in isopropyl alcohol at 60°C for 10 minutes. Then, the surface of the cured film was observed by an optical microscope and evaluated based on the following criteria.
AA: There was observed nothing abnormal on the surface of the cured film.
BB: Whitening or roughening was observed on the surface of the cured film.

### <Synthesis Example 1>

In a 1-liter separable flask, 195 g of styrene, 133 g of glycidyl methacrylate, 172 g of (3-ethyl-3-oxetanyl)methyl acrylate, 15 g of 2,2'-azobisisobutyronitrile (polymerization initiator, referred to as "AIBN" hereinafter) and 350 g of propylene glycol monomethyl ether acetate (referred to as "PGMEA" hereinafter) were placed, then stirring was started, and the interior of the flask was allowed to be in a nitrogen atmosphere. After the reaction solution was heated to 70°C and stirred for 3 hours, 10 g of AIBN was added, followed by stirring for another 1 hour at the same temperature. Subsequently, the reaction solution was heated to 100°C and stirred for 3 hours, and then heating was terminated to complete the reaction, whereby a solution of a copolymer (A-1) having a solid content of 49% by weight was obtained.

### <Synthesis Example 2>

In a 1-liter separable flask, 171 g of styrene, 78 g of glycidyl methacrylate, 101 g of (3-ethyl-3-oxetanyl)methyl methacrylate, 15 g of AIBN and 350 g of 2-heptanone were placed, then stirring was started, and the interior of the flask was allowed to be in a nitrogen atmosphere. After the reaction solution was heated to 70°C and stirred for 3 hours, 10 g of AIBN was added, followed by stirring for another 1 hour at the same temperature. Subsequently, the reaction solution was heated to 100°C and stirred for 3 hours, and then heating was terminated to complete the reaction, whereby a solution of a copolymer (A-2) having a solid content of 49% by weight was obtained.

### <Synthesis Example 3>

In a 1-liter separable flask, 108 g of styrene, 110 g of glycidyl methacrylate, 132 g of (3-ethyl-3-oxetanyl)methyl acrylate, 15 g of AIBN and 350 g of PGMEA were placed, then stirring was started, and the interior of the flask was allowed to be in a nitrogen atmosphere. After the reaction solution was heated to 70°C and stirred for 3 hours, 10 g of AIBN was added, followed by stirring for another 1 hour at the same temperature. Subsequently, the reaction solution was heated to 100°C and stirred for 3 hours, and then heating was terminated to complete the reaction, whereby a solution of a copolymer (A-3) having a solid content of 49% by weight was obtained.

### <Example 1>

The solution of the copolymer (A-1) in such an amount that the solid content became 100 parts by weight and the acid generator (B-1) in an amount of 5 parts by weight were blended as shown in Table 1 to prepare a photosensitive insulating resin composition. Properties of the composition were measured in accordance with the aforesaid evaluation methods. The results are set forth in Table 2.

### <Examples 2 and 3>

Photosensitive insulating resin compositions having formulations shown in Table 1 were prepared in the same manner as in Example 1. Then, properties of the compositions were measured in the same manner as in Example 1. The results are set forth in Table 2.

### <Comparative Examples 1 and 2>

Photosensitive insulating resin compositions having formulations shown in Table 1 were prepared in the same manner as in Example 1. Then, properties of the compositions were measured in the same manner as in Example 1. The results are set forth in Table 2.

**Table 1**

| | (A) Copolymer (parts by weight) | | | (B) Acid generator (parts by weight) | | (C) Epoxy resin, Oxetane compound (parts by weight) | |
|---|---|---|---|---|---|---|---|
| | A-1 | A-2 | A-3 | B-1 | B-2 | C-1 | C-2 |
| Ex. 1 | 100 | - | - | 5 | - | - | - |
| Ex. 2 | - | 100 | - | - | 5 | - | - |
| Ex. 3 | - | - | 100 | 5 | - | - | - |
| Comp. Ex. 1 | - | - | - | - | 5 | 100 | - |
| Comp. Ex. 2 | - | - | - | 5 | - | - | 100 |

The components described in Table 1 are as follows.

### (B) Photosensitive acid generator

B-1: (4-phenylthio)phenyldiphenylsulfonium hexafluorophosphate
B-2: (4-phenylthio)phenyldiphenylsulfonium hexafluoroantimonate

### (C) Epoxy resin, Oxetane compound

C-1: epoxy resin ("NC-7000L" available from Nippon Kayaku Co., Ltd.)
C-2: oxetane compound ("XDO" available from Toagosei Co., Ltd.)

**Table 2**

| | Resolution | Electrical insulation | | Thermal shock resistance | Chemical resistance |
|---|---|---|---|---|---|
| | | Before test | After test | | |
| | (µm) | (Ω·cm) | (Ω·cm) | (cycle) | |
| Ex. 1 | 10 | 3x10¹⁶ | 6x10¹⁴ | 1000 | AA |
| Ex. 2 | 10 | 3x10¹⁶ | 5x10¹⁴ | 1000 | AA |
| Ex. 3 | 10 | 5x10¹⁶ | 3x10¹⁴ | 1000 | AA |
| Comp. Ex. 1 | 10 | 3x10¹⁶ | 5x10¹⁴ | 200 | AA |
| Comp. Ex. 2 | not resolved | 6x10¹⁶ | short circuit | 100 | BB |

## Claims

1. A photosensitive insulating resin composition comprising:
a copolymer (A) obtained by copolymerizing monomer components containing a vinyl monomer having an epoxy group and a vinyl monomer having an oxetanyl group and another vinyl monomer, a photosensitive acid generator (B), and an organic solvent.

2. The photosensitive insulating resin composition as claimed in claim 1, wherein the another vinyl monomer is an aromatic vinyl compound.

3. The photosensitive insulating resin composition as claimed in claim 2, wherein the aromatic vinyl compound is styrene.

4. The photosensitive insulating resin composition as claimed in claim 1, wherein the photosensitive acid generator (B) is contained in an amount of 0.1 to 20 parts by weight based on 100 parts by weight of the copolymer (A).

5. The photosensitive insulating resin composition as claimed in claim 1, wherein the total amounts of the vinyl monomer having an epoxy group and the vinyl monomer having an oxetanyl group contained in the monomer components are not less than 20 parts by weight based on 100 parts by weight of the monomer components.

6. The photosensitive insulating resin composition as claimed in claim 1, wherein the vinyl monomer having an epoxy group is glycidyl (meth)acrylate.

7. The photosensitive insulating resin composition as claimed in claim 1, wherein the vinyl monomer having an oxetanyl group is (3-ethyl-3-oxetanyl)methyl (meth)acrylate.

8. The photosensitive insulating resin composition as claimed in claim 1, wherein the photosensitive acid generator (B) is an onium salt compound.

9. The photosensitive insulating resin composition as claimed in claim 1, wherein the organic solvent is at least one selected from propylene glycol monoalkyl ethers and ketones.

10. A cured product obtained by curing the photosensitive insulating resin composition of any one of claims 1 to 9.

11. An electronic part having a surface protective film and/or a layer insulating film formed by the use of the photosensitive insulating resin composition of any one of claims 1 to 9.

## Patentansprüche

1. Lichtempfindliche isolierende Harzzusammensetzung, die umfasst:
Ein Copolymer (A), das durch Copolymerisieren von Monomerbestandteilen erhalten wird, die ein Vinylmonomer mit einer Epoxygruppe und ein Vinylmonomer mit einer Oxetanylgruppe und ein weiteres Vinylmonomer enthält, einen lichtempfindlichen Säuregenerator (B) und ein organisches Lösungsmittel.

2. Lichtempfindliche isolierende Harzzusammensetzung wie in Anspruch 1 beansprucht, wobei das weitere Vinylmonomer eine aromatische Vinylverbindung ist.

3. Lichtempfindliche isolierende Harzzusammensetzung wie in Anspruch 2 beansprucht, wobei die aromatische Vinylverbindung Styrol ist.

4. Lichtempfindliche isolierende Harzzusammensetzung wie in Anspruch 1 beansprucht, wobei der lichtempfindliche Säuregenerator (B) in einer Menge von 0,1 bis 20 Gewichtsteilen basierend auf 100 Gewichtsteilen des Copolymers (A) enthalten ist.

5. Lichtempfindliche isolierende Harzzusammensetzung wie in Anspruch 1 beansprucht, wobei die Gesamtmengen des Vinylmonomers mit einer Epoxygruppe und des Vinylmonomers mit einer Oxetanylgruppe, die in den Monomerbestandteilen enthalten sind, nicht weniger als 20 Gewichtsteile basierend auf 100 Gewichtsteilen der Monomerbestandteile sind.

6. Lichtempfindliche isolierende Harzzusammensetzung wie in Anspruch 1 beansprucht, wobei das Vinylmonomer mit einer Epoxygruppe Glycidyl(meth)acrylat ist.

7. Lichtempfindliche isolierende Harzzusammensetzung wie in Anspruch 1 beansprucht, wobei das Vinylmonomer mit einer Oxetanylgruppe (3-Ethyl-3-oxetanyl)methyl(meth)acrylat ist.

8. Lichtempfindliche isolierende Harzzusammensetzung wie in Anspruch 1 beansprucht, wobei der lichtempfindliche Säuregenerator (B) eine Oniumsalzverbindung ist.

9. Lichtempfindliche isolierende Harzzusammensetzung wie in Anspruch 1 beansprucht, wobei das organische Lösungsmittel wenigstens eines ausgewählt aus Propylenglycolmonoalkylethern und Ketonen ist.

10. Gehärtetes Produkt, erhalten durch Härten der lichtempfindlichen isolierenden Harzzusammensetzung nach einem der Ansprüche 1 bis 9.

11. Elektronisches Teil mit einem Oberflächenschutzüberzug und/oder einem Schichtisolationsüberzug, gebildet durch die Verwendung der lichtempfindlichen isolierenden Harzzusammensetzung nach einem der Ansprüche 1 bis 9.

## Revendications

1. Composition de résine isolante photosensible comprenant :
un copolymère (A) obtenu par copolymérisation de composants monomères contenant un monomère de vinyle ayant un groupe époxy et un monomère de vinyle ayant un groupe oxétanyle et un autre monomère de vinyle, un générateur d'acide photosensible (B), et un solvant organique.

2. Composition de résine isolante photosensible selon la revendication 1, dans laquelle l'autre monomère de vinyle est un composé de vinyle aromatique.

3. Composition de résine isolante photosensible selon la revendication 2, dans laquelle le composé de vinyle aromatique est le styrène.

4. Composition de résine isolante photosensible selon la revendication 1, dans laquelle le générateur d'acide photosensible (B) est contenu en une quantité de 0,1 à 20 parties en poids pour 100 parties en poids de copolymère (A) .

5. Composition de résine isolante photosensible selon la revendication 1, dans laquelle les quantités totales du monomère de vinyle ayant un groupe époxy et du monomère de vinyle ayant un groupe oxétanyle contenus dans les composants monomères ne sont pas inférieures à 20 parties en poids pour 100 parties en poids des composants monomères.

6. Composition de résine isolante photosensible selon la revendication 1, dans laquelle le monomère de vinyle ayant un groupe époxy est un (méth)acrylate de glycidyle.

7. Composition de résine isolante photosensible selon la revendication 1, dans laquelle le monomère de vinyle ayant un groupe oxétanyle est un (méth)acrylate de (3-éthyl-3-oxétanyl)méthyle.

8. Composition de résine isolante photosensible selon la revendication 1, dans laquelle le générateur d'acide photosensible (B) est un composé de type sel d'onium.

9. Composition de résine isolante photosensible selon la revendication 1, dans laquelle le solvant organique est au moins un solvant organique choisi parmi les éthers et les cétones monoalkyliques de propylène glycol.

10. Produit durci obtenu par durcissement de la composition de résine isolante photosensible selon l'une quelconque des revendications 1 à 9.

11. Pièce électronique comportant un film protecteur superficiel et/ou une couche de film isolant formé à l'aide de la composition de résine isolante photosensible selon l'une quelconque des revendications 1 à 9.
